Europäisches Patentamt

European Patent Office

Office européen des brevets

(11) Veröffentlichungsnummer: **0 140 333**
**A2**

# (12) EUROPÄISCHE PATENTANMELDUNG

(21) Anmeldenummer: **84112794.7**

(22) Anmeldetag: **24.10.84**

(51) Int. Cl.⁴: **H 03 G 3/32**

(30) Priorität: **28.10.83 DE 3339108**

(43) Veröffentlichungstag der Anmeldung:
**08.05.85 Patentblatt 85/19**

(84) Benannte Vertragsstaaten:
**DE FR GB IT NL SE**

(71) Anmelder: **International Standard Electric Corporation**
**320 Park Avenue**
**New York New York 10022(US)**

(84) Benannte Vertragsstaaten:
**FR GB IT NL SE**

(71) Anmelder: **Standard Elektrik Lorenz Aktiengesellschaft**
**Hellmuth-Hirth-Strasse 42**
**D-7000 Stuttgart 40(DE)**

(84) Benannte Vertragsstaaten: -
**DE**

(72) Erfinder: **Walker, Michael**
**Ringstrasse 6**
**D-7066 Baltmannsweiler(DE)**

(74) Vertreter: **Pohl, Heribert, Dipl.-Ing et al,**
**Standard Elektrik Lorenz AG Patent- und Lizenzwesen**
**Kurze Strasse 8 Postfach 300 929**
**D-7000 Stuttgart 30(DE)**

(54) **Tonwiedergabesystem.**

(57) Entsprechend der Erfindung wird ein der Tonwiedergabe dienender Lautsprecher gleichzeitig zur Ermittlung des Umgebungsgeräusches verwendet. Hierzu werden Istspannung und Sollspannung am Lautsprecher miteinander verglichen. Die Differenz ist abhängig vom Schallereignis am Ort des Lautsprechers, durch das im Lautsprecher Mikrophoniespannungen entstehen.

Mit einem erfindungsgemäßen Tonwiedergabesystem kann die Lautstärke und die Dynamik einer Tonwiedergabe automatisch an die Umgebungslautstärke angepaßt werden. Anwendung beispielsweise im Kraftfahrzeug.

Fig.1

Croydon Printing Company Ltd.

M.Walker-2

## Tonwiedergabesystem

Die Erfindung betrifft ein Tonwiedergabesystem mit einer Tonsignalquelle, einem Verstärker und einem Lautsprecher.

Bei Tonwiedergabesystemen ist es manchmal erwünscht, das tatsächliche Schallereignis am Ort des Lautsprechers zu kennen. Dies ist beispielsweise dann erforderlich, wenn im Lautsprecher oder im Verstärker auftretende Verzerrungen erkannt und ausgeglichen werden sollen. Eine andere Anwendungsmöglichkeit ist beispielsweise dort gegeben, wo die Umgebungslautstärke festgestellt werden soll, um die Lautstärke der Tonwiedergabe daran anzupassen.

Es ist bekannt, hierfür ein Mikrophon zu verwenden, das in der Nähe des Lautsprechers aufgestellt oder direkt an diesem befestigt ist.

Vor allem dort, wo Lautsprecher bereits fest eingebaut sind, ist es in der Regel kaum möglich, auch noch ein Mikrophon in der Nähe des Lautsprechers anzubringen.

ZT/P2-Bs/Gn
24.10.1983                                        - 5 -

M.Walker-2

Der Erfindung liegt die Aufgabe zugrunde, das Schallereignis am Ort eines Lautsprechers zu ermitteln, ohne in unmittelbarer Nähe ein Mikrophon anbringen zu müssen.

Die Aufgabe wird erfindungsgemäß gelöst durch die Lehre des Hauptanspruchs. Vorteilhafte Ausgestaltungen der Erfindung sind den Unteransprüchen zu entnehmen.

Der Erfindung liegt die Tatsache zugrunde, daß ein Lautsprecher auch als Mikrophon verwendbar ist und daß diese Eigenschaft auch beim bestimmungsgemäßen Gebrauch des Lautsprechers nicht verloren geht.

Im folgenden wird die Erfindung anhand von Ausführungsbeispielen unter Zuhilfenahme der beiliegenden Zeichnung weiter erläutert.

Die drei Figuren zeigen jeweils ein Blockschaltbild eines erfindungsgemäßen Tonwiedergabesystemes.

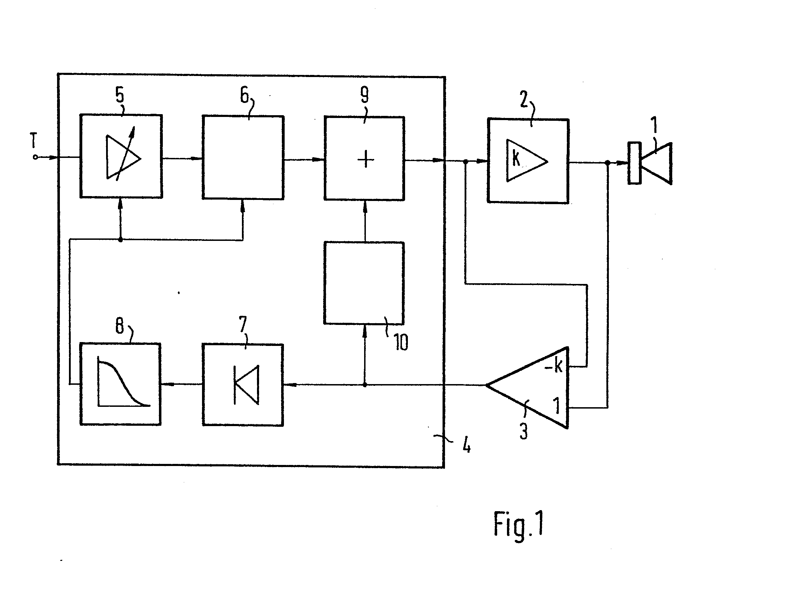

Anhand des in Fig. 1 gezeigten Ausführungsbeispiels wird zum einen das Grundprinzip der Erfindung erläutert, zum anderen werden vorteilhafte Ausgestaltungen der Erfindung aufgezeigt. Das von einer Tonsignalquelle T kommende Tonsignal gelangt über eine Auswerteschaltung 4 an den Eingang eines Verstärkers 2 und nach Verstärkung mit dem Verstärkungsfaktor k an einen Lautsprecher 1. Am Lautsprecher 1 wird das elektrische Tonsignal in ein akustisches Signal, d.h. in Druckschwankungen umgewandelt. Schwankt gleichzeitig auch der Außendruck, so gibt dies Rückwirkungen auf den Lautsprecher. Das Schallereignis am Ort des Lautsprechers hat somit eine Mikrophoniespannung am Lautsprechereingang zur Folge. Diese Mikrophoniespannung kann

ausgewertet werden, wenn sie vom Nutzsignal - dem vom Lautsprecher wiederzugebenden Tonsignal - abgetrennt wird. Dies erfolgt in einer Subtrahierschaltung 3. In der Subtrahierschaltung 3 wird das Eingangssignal des Verstärkers 2 in der Amplitude um den Verstärkungsfaktor k des Verstärkers 2 angehoben und vom Eingangssignal des Lautsprechers 1 subtrahiert. Wenn die Subtrahierschaltung 3 dasselbe Frequenzverhalten aufweist wie der Verstärker 2, so ist am Ausgang der Subtrahierschaltung 3 ausschließlich eine der Mikrophoniespannung proportionale Spannung abnehmbar.

Das Ausgangssignal der Subtrahierschaltung 3 kann verwendet werden, um das Schallereignis am Ort des Lautsprechers hörbar zu machen, beispielsweise bei einer einfachen Gegensprechanlage. In diesem Fall entfällt die Auswerteschaltung 4. Die Tonsignalquelle T ist dann direkt mit dem Eingang des Verstärkers 2 verbunden. Das Ausgangssignal der Subtrahierschaltung 3 kann aber auch dazu verwendet werden, um über die Auswerteschaltung 4 das von der Tonsignalquelle T kommende Tonsignal so zu beeinflussen, daß dessen Wiedergabe durch den Lautsprecher 1 möglichst gut wahrgenommen werden kann.

Das von der Tonsignalquelle T kommende Tonsignal durchläuft in der Auswerteschaltung 4 einen Vorverstärker 5, dessen Verstärkungsfaktor durch ein elektrisches Signal veränderbar ist. Dieses elektrische Signal wird vom Ausgangssignal der Subtrahierschaltung 3 abgeleitet und wirkt so, daß bei größerer Umgebungslautstärke die Verstärkung des Vorverstärkers größer wird. Die Lautsprecherwiedergabe paßt sich somit in der Lautstärke an die Umgebungslautstärke an. Das Steuersignal zur Beeinflussung des Verstärkungsfaktors des Vorverstärkers 5 wird aus dem Ausgangssignal der Subtrahierschaltung 3 durch Gleichrichtung in einem Gleich-

M.Walker-2

richter 7 und Filterung in einem Tiefpaß 8 gewonnen.

Das von der Tonsignalquelle T kommende Tonsignal durchläuft außerdem einen Dynamikkompressor 6, dessen Kompressionsfaktor durch ein elektrisches Signal veränderbar ist. Im gezeigten Ausführungsbeispiel wird der Kompressionsfaktor des Dynamikkompressors 6 und der Verstärkungsfaktor des Vorverstärkers 5 durch dasselbe Signal beeinflußt. Die Beeinflussung ist derart, daß bei zunehmender Umgebungslautstärke der Kompressionsfaktor ebenfalls zunimmt, so daß die leisen Stellen in der Lautstärke angehoben werden, während die lauten Stellen unverändert bleiben.

Sowohl die Veränderung der Lautstärke im Vorverstärker 5 als auch die Beeinflussung des Dynamikumfangs im Dynamikkompressor 6 bewirken, daß die Tonwiedergabe auch bei starken Umgebungsgeräuschen verständlich bleibt und dennoch auch bei geringen oder fehlenden Umgebungsgeräuschen nicht als unangenehm empfunden wird. Ein einstellbarer Vorverstärker oder ein einstellbarer Dynamikkompressor könnten schon je für sich die Verständlichkeit bei wechselnden Umgebungsbedingungen verbessern. Das Steuersignal zur Einstellung des Verstärkungsfaktors und des Kompressionsfaktors könnte auch auf andere als die gezeigte Art aus dem Ausgangssignal der Subtrahierschaltung 3 gewonnen werden. Beispielsweise könnte an die Stelle der Gleichrichtung im Gleichrichter 7 eine Effektivwertbildung treten. Auch können die beiden Steuersignale zur Veränderung des Verstärkungsfaktors und des Kompressionsfaktors unterschiedlich gebildet werden, beispielsweise durch Tiefpässe mit unterschiedlicher Grenzfrequenz. Im bevorzugten Ausführungsbeispiel ist die Abhängigkeit von Verstärkungsfaktor und Kompressionsfaktor einerseits und dem diese Faktoren beeinflussenden Steuersignal andererseits so, daß bei ansteigendem Geräuschpegel

M.Walker-2

zunächst der Kompressionsfaktor ansteigt und bei weiter ansteigendem Geräuschpegel auch der Verstärkungsfaktor anzusteigen beginnt. Dies hat zur Folge, daß erst der Lautstärkepegel der leisen Stellen an den der lauten Stellen angenähert wird, bevor die Lautstärke insgesamt erhöht wird.

Die Ansteuerschaltung 4 weist im gezeigten Ausführungsbeispiel außerdem noch eine Addierschaltung 9 und ein Netzwerk 10 auf. Das Ausgangssignal der Subtrahierschaltung 3 wird in der Addierschaltung 9 zum Eingangssignal des Verstärkers 2 addiert, nachdem es im Netzwerk 10 nach Betrag und Phase so beeinflußt wurde, daß sich die Addition dieses Signals so auswirkt, daß dadurch das Ausgangssignal der Subtrahierschaltung 3 kleiner wird. Dadurch können Verzerrungen ausgeglichen werden, die im Verstärker 2 und im Lautsprecher 1 entstehen. Das Netzwerk 10 kann außerdem bandbegrenzende Wirkung aufweisen. Damit kann die durch die Addierschaltung 9 sich ergebende Kompensation auf solche Frequenzen beschränkt werden, bei denen einerseits größere Verzerrungen auftreten und die andererseits im Umgebungsgeräusch (z.B. Motorenlärm) nur in geringem Maß zu erwarten sind. Ansonsten ist die Funktion der Addierschaltung 9 unabhängig von der Funktion des Vorverstärkers 5 und des Dynamikkompressors 6 und kann somit auch unabhängig davon eingesetzt werden.

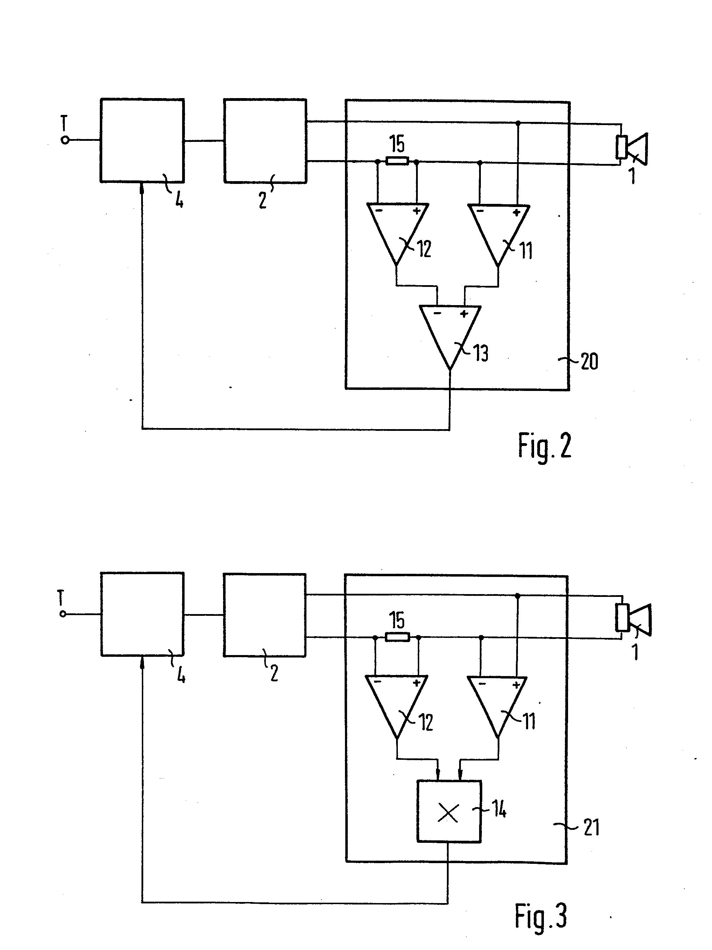

Anhand der Fig. 2 wird ein weiteres Ausführungsbeispiel eines erfindungsgemäßen Tonwiedergabesystems beschrieben. Gegenüber dem anhand der Fig. 1 beschriebenen Ausführungsbeispiel ist in dem hier gezeigten Ausführungsbeispiel die Subtrahierschaltung 3 durch eine anders aufgebaute Meßschaltung 20 ersetzt. Wenn der Ausgang

M.Walker-2

des Verstärkers 2 sehr niederohmig ist, dann wird dadurch die im Lautsprecher 1 entstehende Mikrophoniespannung weitgehend kurzgeschlossen und ist somit nicht mehr auswertbar. Die Meßschaltung 20 enthält deshalb einen Meßwiderstand 15, der mit dem Lautsprecher 1 in Reihe liegt. Mittels dieses Meßwiderstands 15 kann der durch den Lautsprecher 1 fließende Strom gemessen werden. Durch zwei getrennte Spannungsmesser 11 und 12, die jeweils durch einen Differenzverstärker verwirklicht sind, wird einerseits (Spannungsmesser 11) die Spannung am Lautsprecher 1 und andererseits (Spannungsmesser 12) der Strom durch den Lautsprecher 1 als Spannungsabfall am Meßwiderstand 15 gemessen. Eine Subtrahierschaltung 13 bildet die Differenz der beiden durch die Spannungsmesser 11 und 12 gemessenen Spannungen.

Die Schaltung nach Fig. 2 wirkt wie folgt:
Wirkt keine im Lautsprecher 1 erzeugte Mikrophoniespannung, so sind die am Lautsprecher 1 und die am Meßwiderstand 15 anliegenden Spannungen direkt proportional zur Ausgangsspannung des Verstärkers 2. Sie weisen beide die gleiche Phase auf. Die beiden von den Spannungsmessern 11 und 12 gemessenen Spannungen unterscheiden sich damit nur um einen festen Faktor, der dem Verhältnis von Lautsprecherwiderstand zu Meßwiderstand entspricht. Erfolgt die Subtraktion in der Subtrahierschaltung 13 unter Berücksichtigung dieses Faktors, so wirken sich diese beiden Spannungen am Ausgang der Subtrahierschaltung 13 nicht mehr aus.

Ist ausschließlich eine im Lautsprecher 1 erzeugte Mikrophoniespannung vorhanden, so ist die Spannung am Lautsprecher 1 gleich dieser Mikrophoniespannung, die Spannung am Meßwiderstand 15 proportional dazu, in der Phase jedoch um

M.Walker-2

180° gedreht. Die Spannung am Ausgang der Subtrahierschaltung 13 ist damit direkt proportional zur Mikrophoniespannung.

Am Ausgang der Subtrahierschaltung 13 wirkt sich damit ausschließlich die Mikrophoniespannung aus. Die Ausgangsspannung der Subtrahierschaltung 13 in der Schaltung nach Fig. 2 wird genau so weiterverarbeitet wie die Ausgangsspannung der Subtrahierschaltung 3 in der Schaltung nach Fig. 1.

In der Schaltung nach Fig. 3 ist die Meßschaltung 20 gemäß der Schaltung von Fig. 2 durch eine andersartige Meßschaltung 21 ersetzt. Diese unterscheidet sich von der Meßschaltung 20 in der Schaltung nach Fig. 2 dadurch, daß die Subtrahierschaltung 13 durch eine Multiplizierschaltung 14 ersetzt ist. Da die Spannungsmesser 11 und 12 Spannungen messen, die einerseits einen Spannungswert und andererseits einem Stromwert entsprechen, ergibt die Multiplikation dieser beiden Werte einen Leistungswert. Die Ausgangsspannung der Multiplizierschaltung 14 ist proportional dem Augenblickswert der Differenz der vom Verstärker 2 abgegebenen Leistung und der Leistung, die aus der im Lautsprecher 1 erzeugten Mikrophoniespannung resultiert. Im zeitlichen Mittel ist zwar die vom Verstärker 2 abgegebene Leistung wesentlich größer als die durch Mikrophonie entstandene Leistung, bei Null-Durchgängen der am Ausgang des Verstärkers 2 abgegebenen Spannung wirkt sich jedoch ausschließlich die Mikrophoniespannung aus. Da das Tonsignal und das Mikrophoniesignal nicht miteinander korreliert sind und sich die zugehörigen Leistungen mit entgegengesetztem Vorzeichen auswirken, sind zumindest die posi-

M.Walker-2

tiven und negativen Spitzenwerte eindeutig dem einen oder dem anderen Signal zuzuordnen. Das Schallereignis am Ort des Lautsprechers kann damit zwar nicht direkt gewonnen werden, es kann aber eine Information gewonnen werden, die ausschließlich von der Umgebungslautstärke abhängt. Der Ausgleich von Verzerrungen über eine Addierschaltung 9 in der Auswerteschaltung 4 ist damit nicht möglich. Bei Gewinnung der richtigen Polarität im Gleichrichter 7 kann das Ausgangssignal der Multiplizierschaltung 14 jedoch in gleicher Weise verwendet werden wie das Ausgangssignal der Subtrahierschaltung 3 in der Schaltung nach Fig. 1.

Am Ausgang der Multiplizierschaltung 14 sind zwar die positiven und die negativen Spitzenwerte eindeutig einerseits dem Tonsignal und andererseits dem Mikrophoniesignal zugeordnet, der dem Tonsignal zugeordnete Spitzenwert ist jedoch im Durchschnitt weit größer als der allein gewünschte, dem Mikrophoniesignal zugeordnete Spitzenwert. Der Aussteuerbereich der Multiplizierschaltung 14 muß deshalb sehr ungleich zu Ungunsten des Mikrophoniesignals aufgeteilt werden, wenn nicht eine Übersteuerung durch das Tonsignal in Kauf genommen wird. Dies kann umgangen werden durch eine zusätzliche Subtrahierschaltung, deren Eingänge wie die der Subtrahierschaltung 13 in der Schaltung nach Fig. 2 mit den Ausgängen der beiden Spannungsmesser 11 und 12 verbunden sind und deren Ausgang anstelle des Ausgangs des Spannungsmessers 11 mit einem Eingang der Multiplizierschaltung 14 verbunden ist, deren anderer Eingang mit dem Ausgang des Spannungsmessers 12 verbunden bleibt.. Die zwischengeschaltete Subtrahierschaltung muß dabei etwas unsymmetrisch aufgebaut sein, so daß an ihrem Ausgang das Signal des Spannungsmessers 11 überwiegt. Die zusätzliche Subtrahierschal-

M.Walker-2

tung hat zwar eine Verzerrung des Ausgangssignals der
Multiplizierschaltung 14 zur Folge, der allein gewünschte, dem Mikrophoniesignal zugeordnete Spitzenwert bleibt
jedoch erhalten.

M.Walker-2

## Patentansprüche

1. Tonwiedergabesystem mit einer Tonsignalquelle, einem Verstärker und einem Lautsprecher, d a d u r c h   g e - k e n n z e i c h n e t ,   daß eine Meßschaltung (3, 20, 21) vorhanden ist, mit der die im Lautsprecher (1) entstehende Mikrophoniespannung ermittelt wird.

2. Tonwiedergabesystem nach Anspruch 1, dadurch gekennzeichnet, daß die Meßschaltung eine Subtrahierschaltung (3) ist, in der das Eingangssignal des Verstärkers (2) und das Eingangssignal des Lautsprechers (1) entsprechend dem Verstärkungsfaktor des Verstärkers (2) gewichtet voneinander subtrahiert werden.

3. Tonwiedergabesystem nach Anspruch 1, dadurch gekennzeichnet, daß die Meßschaltung (20) einen Meßwiderstand (10) enthält, der in Reihe zum Lautsprecher (1) geschaltet ist, daß sie weiter zwei Spannungsmesser (11, 12) zum Messen der Spannungen am Meßwiderstand (10) und am Lautsprecher (1) enthält und daß sie außerdem eine Subtrahier- schaltung (13) zur Bildung der Differenz der beiden Span- nungen enthält.

ZT/P2-Bs/Gn

24.10.1983

M.Walker-2

4. Tonwiedergabesystem nach Anspruch 1, dadurch gekennzeichnet, daß die Meßschaltung (21) einen Meßwiderstand (10) enthält, der in Reihe zum Lautsprecher
(1) geschaltet ist, daß sie weiter zwei Spannungsmesser
(11, 12) zum Messen der Spannungen am Meßwiderstand (10)
und am Lautsprecher (1) enthält und daß sie außerdem
eine Multiplizierschaltung (14) zur Bildung des Produkts
der beiden Spannungen enthält.

5. Tonwiedergabesystem nach einem der Ansprüche 1 bis 4,
dadurch gekennzeichnet, daß eine Ansteuerschaltung (4)
vorhanden ist, durch die das von der Tonsignalquelle (T)
an den Eingang des Verstärkers (2) geführte Tonsignal
in Abhängigkeit vom Ausgangssignal der Meßschaltung (3,
20, 21) beeinflußbar ist.

6. Tonwiedergabesystem nach Anspruch 5, dadurch gekennzeichnet, daß die Ansteuerschaltung (4) einen Vorverstärker (5) mit veränderbarem Verstärkungsfaktor enthält, daß das Ausgangssignal der Tonsignalquelle (T)
über den Vorverstärker (5) an den Eingang des Verstärkers
(2) geführt ist, daß der Verstärkungsfaktor des Vorverstärkers (5) durch ein elektrisches Signal veränderbar
ist und daß dieses elektrische Signal ein aus dem Ausgangssignal der Meßschaltung (3, 20, 21) gebildetes
Signal ist.

7. Tonwiedergabesystem nach einem der Ansprüche 5 oder
6, dadurch gekennzeichnet, daß die Ansteuerschaltung (4)
einen Dynamikkompressor (6) mit veränderbarem Kompressionsfaktor enthält, daß das Ausgangssignal der Tonsignalquelle (T) über den Dynamikkompressor (6) an den

0140333

M.Walker-2

Eingang des Verstärkers (2) geführt ist, daß der Kompressionsfaktor des Dynamikkompressors (6) durch ein elektrisches Signal veränderbar ist und daß dieses elektrische Signal ein aus dem Ausgangssignal der Meßschaltung (3, 20, 21) gebildetes Signal ist.

8. Tonwiedergabesystem nach Anspruch 6 oder 7, dadurch gekennzeichnet, daß die Ansteuerschaltung (4) einen Gleichrichter (7) mit nachfolgendem Tiefpaß (8) enthält, daß das Ausgangssignal der Meßschaltung (3, 20, 21) nach Gleichrichtung im Gleichrichter (7) und Filterung im Tiefpaß (8) den Verstärkungsfaktor des Vorverstärkers (5) und/oder den Kompressionsfaktor des Dynamikkompressors (6) verändert und daß diese Veränderung derart ist, daß der Verstärkungs- und/oder Kompressionsfaktor ansteigt, wenn das Ausgangssignal des Tiefpasses (8) ansteigt.

9. Tonwiedergabesystem nach einem der Ansprüche 5 bis 8, dadurch gekennzeichnet, daß die Ansteuerschaltung (4) eine Addierschaltung (9) enthält, in der das Ausgangssignal der Meßschaltung (3, 20) oder ein bandbegrenzter Teil desselben nach Betrag und Phase derart zum Eingangssignal des Verstärkers (2) addiert wird, daß das Ausgangssignal der Meßschaltung (3, 20) kleiner wird.

Fig.1

M. Walker Z
21. 2. 84

Fig. 2

Fig.3

M. Walker Z
21. 2. 84